# EUROPÄISCHE PATENTANMELDUNG

(11) **EP 1 887 700 A2**
(43) Veröffentlichungstag der Anmeldung: **13.02.2008**
(21) Anmeldenummer: 07013536.3
(22) Anmeldetag: 11.07.2007
(51) Int. Cl.: H03K 23/48

(54) **Digitaler Taktteiler und Verfahren zum Betreiben eines Taktteilers**

(30) Priorität: 09.08.2006 DE 102006037436
(71) Anmelder: Micronas GmbH, 79108 Freiburg (DE)
(72) Erfinder: Noeske, Carsten, 79350 Sexau (DE)
(74) Vertreter: Patentanwälte Westphal, Mussgnug & Partner

(57) **Zusammenfassung**

Die Erfindung bezieht sich insbesondere auf einen digitalen Taktteiler mit einem Addierer (5) und einer Taktteilungseinrichtung (1), an der ein erster Takt (clk0) mit einer ersten hohen Frequenz (fin) anliegt und die einen zweiten Takt (clk1) mit einer relativ zur ersten Frequenz (fin) niedrigeren zweiten Frequenz (fout) ausgibt, wobei eine Teilungswert-Teilungseinrichtung (6) ausgebildet ist, einen vom Addierer (5) ausgegebenen Additionswert (i, f) in einen ganzzahligen Wert (i) und einen Fraktionalanteil (f) aufzuteilen, eine Rückkoppelungsstrecke (7; 7, 14) den Fraktionalanteil (f) für eine spätere Addition zum Addierer (5) zurückführt, der Addierer (5) den zurückgeführten Fraktionalanteil (f) auf einen anliegenden Teilungswert (x) aufaddiert und die Taktteilungseinrichtung (1) auf Basis des ganzzahligen Werts (i) gesteuert wird.

## Beschreibung

Die Erfindung bezieht sich auf einen digitalen Taktteiler mit den oberbegrifflichen Merkmalen gemäß Patentanspruch 1 bzw. auf ein Verfahren zum Betreiben eines digitalen Taktteilers.

In modernen SoC-Systamen (SoC: System-on-Chip) werden asynchrone Takte durch digitale Taktteiler bereitgestellt. Dabei wird den digitalen Taktteilern ein erster Takt mit einer relativ hohen Frequenz angelegt und von den Taktteilern aus der ersten hohen Frequenz mittels eines am Taktteiler anliegenden Steuersignals ein zweiter Takt mit einer relativ zur ersten Frequenz niedrigeren Frequenz erzeugt und ausgegeben. Die Frequenz variiert dabei von Intervall zu Intervall abhängig vom mittels des Steuersignals angelegten Teilerfaktor. In der Regel liegt dabei der resultierende Jitter innerhalb des für digitale Schnittstellen zulässigen Jitters.

Die Taktteiler verwenden üblicherweise einen so genannten digitalen Steuer-Oszilliator (DCO). Bei entsprechenden Anordnungen löst jeder Eingangstakt eine Addition mit einem definierten Offset auf einen Akkumulator aus. Der Akkumulator lässt einen Überlauf zu, so dass das signifikanteste Bit (MSB / Most Significant Bit) einen Takt auf niedrigerer Rate darstellt, welcher proportional zum Offset ist.

Nachteilhaft an einer solchen Anordnung ist, dass eine Addition auf der sehr hohen Eingangsrate stattfinden muss, was einen hohen Stromverbrauch des Taktteilers zur Folge hat. Zudem ist nachteilhaft, dass die programmierbaren Ausgangsfrequenzen gleichmäßig über den Bereich zwischen null und der Eingangsfrequenz verteilt sind. Folglich sind sehr große Bitbreiten des Akkumulators von Nöten, um eine adäquate Frequenzauflösung zu erreichen. Die große Bitbreite des Akkumulators wirkt sich ebenfalls nachteilhaft auf den Stromverbrauch aus.

Außerdem nachteilhaft ist, dass der Jitter dem eines Rauschformers (Noice-Shapers) erster Ordnung vergleichbar ist, wodurch tieffrequente Störlinien im Spektrum des Ausgangstakts auftreten können. Solche Störlinien können bei einer Rückgewinnung des ohne Jitter bereitzustellenden Taktes zu Problemen bzw. im Fall von einem Einsatz im Audiobereich zu Pfeiftönen führen.

Die Aufgabe der Erfindung besteht darin, einen digitalen Taktteiler bzw. ein Verfahren zum Betreiben eines digitalen Taktteilers zu verbessern. Insbesondere soll ein reduzierter Stromverbrauch erzielt werden. Vorzugsweise soll auch Jitter reduziert werden bzw. eine bessere spektrale Formung eines momentanen Fehlers von dem idealen, unverjitterten Takt ermöglicht werden.

Diese Aufgabe wird gelöst durch einen digitalen Taktteiler mit den Merkmalen gemäß Patentanspruch 1 bzw. durch ein Verfahren zum Betreiben eines digitalen Taktteilers mit den Merkmalen gemäß Patentanspruch 13. Vorteilhafte Ausgestaltungen sind Gegenstand abhängiger Ansprüche.

Bevorzugt wird demgemäss ein digitaler Taktteiler mit einem Addierer und einer Taktteilungseinrichtung, an der ein erster Takt mit einer ersten hohen Frequenz anliegt und die einen zweiten Takt mit einer relativ zur ersten Frequenz niedrigeren zweiten Frequenz ausgibt, wobei eine Teilungswert-Teilungseinrichtung ausgebildet ist, einen vom Addierer ausgegebenen Additionswert in einen ganzzahligen Wert und einen Fraktionalanteil aufzuteilen, eine Rückkoppelungsstrecke den Fraktionalanteil für eine spätere Addition zum Addierer zurückführt, der Addierer den zurückgeführten Fraktionalanteil oder einen von einer Verarbeitungseinrichtung modifizierten Fraktionalanteil auf einen anliegenden Teilungswert aufaddiert und die Taktteilungseinrichtung auf Basis des ganzzahligen Werts gesteuert wird.

Zumindest der Addierer und die Teilungswert-Teilungseinrichtung werden vorzugsweise mittels des zweiten Takts getaktet betrieben, also mittels eines Taktes mit einer niedrigeren Taktrate als der des ersten Taktes.

In die Rückkoppelungsstrecke ist vorzugsweise eine Verzögerungseinrichtung geschaltet zum verarbeiteten, insbesondere verzögerten Rückführen des Fraktionalanteils. Diese Verzögerungseinrichtung kann eine Filterung mit einer Übertragungsfunktion beinhalten, womit der Taktteiler im Mittel die richtige Frequenz generiert.

Die Übertragungsfunktion H(z) kann vorzugsweise mittels mehrerer Rückkoppelungsstrecken zum verschieden stark verzögerten Rückführen des Fraktionalanteils zum Addierer ausgeführt werden.
In die eine Rückkoppelungsstrecke oder mehrere Rückkoppelungsstrecken sind bevorzugt Multiplizierer, Dividierer, Inverter und Shifter zum Wichten der rückgeführten Fraktionalanteile geschaltet. Dadurch werden vorteilhaft Rauschformer höherer Ordnung ausgebildet, welche mit geeigneten Wichtungsfaktoren zur spektralen Formung des Jitters einsetzbar sind.

Eine Teilungswert-Speichereinrichtung ist vorzugsweise angeordnet, den an dem Addierer anliegenden Teilungswert bereitzustellen.

Eine bevorzugt zwischen die Teilungswert-Teilungseinrichtung und die Taktteilungseinrichtung geschaltete Zwischenspeichereinrichtung speichert den ganzzahligen Wert zwischen.

Die Taktteilungseinrichtung zählt gemäß einer Ausführungsform den ganzzahligen Wert in einem nicht-binären Zahlensystem ab.

Die Taktteilungseinrichtung zählt den ganzzahligen Wert bevorzugt mit einem Chain-Counter ab.

Zwischen die Teilungswert-Teilungseinrichtung und die Taktteilungseinrichtung ist vorzugsweise ein Recoder-Block geschaltet ist, der den ganzzahligen Wert in eine Repräsentation überführt, die von der Taktteilungseinrichtung, die im nicht-binären Zahlensystem zählt, verarbeitet wird. Mit "nicht-binären" Zahlensystem ist ein binäres Zahlensystem gemeint, in dem die Reihenfolge der Zahlen vertauscht worden ist.

Zwischen die Teilungswert-Teilungseinrichtung und die Taktteilungseinxichtung kann auch ein Recoder-Block geschaltet sein, der den ganzzahligen Wert in eine Repräsentation überführt, welche die als ein Chain-Counter (deutsch: Zähler mit rückgekoppelten Schieberegister) implementierte Taktteilungseinrichtung steuert. In dem Fall, dass die Taktteilungseinrichtung als ein so genannter Chain-Counter ausgeführt ist, kann vorzugsweise zwischen die Teilungswert-Teilungseinrichtung und die Taktteilungseinrichtung ein so genannter Chain-Counter-Recoding Block (deutsch: Startbewertungsblock für einen Zähler, der mittels rückgekoppelten Schieberegistern ausgeführt ist) geschaltet sein. Dieser Block setzt die im binären Zahlensystem codierte Steuerinformation für die in einem Chain-Counter benötigte binäre Restklassen-Polynomdarstellung um.

Die Funktionsweise eines Chain counters ist folgende:
"Ein Chain-Counter ist ein Zähler, der auf einem rückgekoppelten Schieberegister beruht. Geeigneterweise wählt man Rückkopplungen bzw. Rückkopplullgspolynome, die eine sogenannte Maximalsequenz (MLS - Maximum Length Sequence) erzeugen, d.h. es werden alle mit der Bitanzahl des Schieberegisters darstellbaren Zahlen durchlaufen. Da die Zahlen in einem Chain-Counter nicht in der normalen Reihenfolge durchlaufen werden, benötigt man bei Zählern mit programmierbaren Zählwert einen Chain-Counter-Recoding Block. Dieser ist ein Block, der den Start- bzw. Endwert ausgehend von dem Zählwert berechnet. Es sind zwei Ausführungen möglich: 1) Man testet auf einen fixen Endwert und hat der Recoding Block generiert den Startwert, von dem aus es n Zyklen dauert, bis der fixe Endwert erreicht ist oder 2) Man startet immer beim gleichen Wert und berechnet den Endwert, bei dem der Zähler fertig gezählt hat. Eine vorteilhafte Ausführung des Chain-Counter-Recoding-Blocks ist eine Tabelle, die einen Eingangswert einem Ausgangswert zuordnet.

Bevorzugt wird eigenständig ein Verfahren zum Betreiben eines digitalen Taktteilers, insbesondere zum Betreiben eines solchen digitalen Taktteilers, wobei bei dem Verfahren auf einen Teilungswert ein Fraktionalanteil aufaddiert wird, wobei der Fraktionalanteil in zyklischer Abfolge vom Additionswert der Addition getrennt und für eine nachfolgende Addition rückgeführt wird und wobei ein ganzzahliger Wert der Addition als Teilerfaktor oder Basis für einen Teilerfaktor einer Taktteilungseinrichtung zum Bereitstellen eines zweiten Takts mit niedrigerer Frequenz aus einem ersten Takt mit höherer Frequenz angelegt wird.

Vorzugsweise wird der Teilerfaktor auf Basis des zweiten Takts erzeugt und bereitgestellt. Der Fraktionalanteil des Additionswertes wird bevorzugt über verschiedene Rückkoppelungsstrecken verschieden stark verzögert rückgeführt. Der oder die rückgeführten Fraktionalanteile können vorteilhaft gewichtet werden.

Bereitgestellt wird somit ein digitaler Taktteiler, welcher auf Basis der niedrigeren Ausgangsrate getaktet einen ganzzahligen Teilerfaktor berechnet, wobei der ganzzahlige Teilerfaktor variiert. Mit diesem Teilerfaktor in Form eines ganzzahligen Wertes wird eine einfache Taktteilungseinrichtung, der ein Takt mit der hohen Eingangsrate anliegt, auf der niedrigen Ausgangsrate angesteuert. Vorzugsweise wird ein solcher temporärer ganzzahliger Teilerfaktor mittels eines Rauschformers generiert, wobei ein Rauschformer auch höherer Ordnungen einsetzbar ist, um eine spektrale Formung des Jitters je nach Bedarf durchführen zu können. Vorteilhaft ist auch eine Recodierung des ganzzahligen Wertes, welcher einen solchen Teilerfaktor bildet, für einen Dezimationszähler in Form beispielsweise eines so genannten Chain-Counters, um die Taktteilungseinrichtung auf der hohen Rate weiter zu vereinfachen.

Dadurch, dass eine Akkumulation auf der Ausgangsrate durchgeführt wird, wird eine deutliche Ersparnis im Leistungsverbrauch des Addierers um den Dezimationsfaktor zwischen Eingangsrate und Ausgangsrate des Taktes erzielbar. Auf einfache Art und Weise werden die höchstsignifikanten Bits des Akkumulators zur Steuerung entweder direkt der Taktteilungseinrichtung oder eines zwischengeschalteten zwischenspeichers oder eines Chain-Counter-Recoding Blockes verwendet.

Die Ausführung der Rückkopplung des fraktionalen Teils des Akkumulators in Form eines Filters höherer Ordnung ermöglicht eine vorteilhafte spektrale Formung des Jitters. Insbesondere können durch geeignete Wahl der Übertragungsfunktion eines solchen Rauschformers diskrete Linien vermieden werden, welche zu Pfeiftönen führen können, wenn der Ausgangstakt für eine Digital-Analog-Wandlung insbesondere im Audiobereich verwendet wird.

Ein Ausführungsbeispiel wird nachfolgend anhand der Zeichnung näher erläutert- Es zeigen:
Fig. 1 allgemeine schematische Darstellung eines Ausführungsbeispiels eines digitalen Taktteilers,
Fig. 2 schematisch Schaltungskomponenten einer ersten beispielhaften Ausführungsform des digitalen Taktteilers und
Fig. 3 eine weitere Ausführungsform eines solchen digitalen Taktteilers mit einem Rauschformer höherer Ordnung.

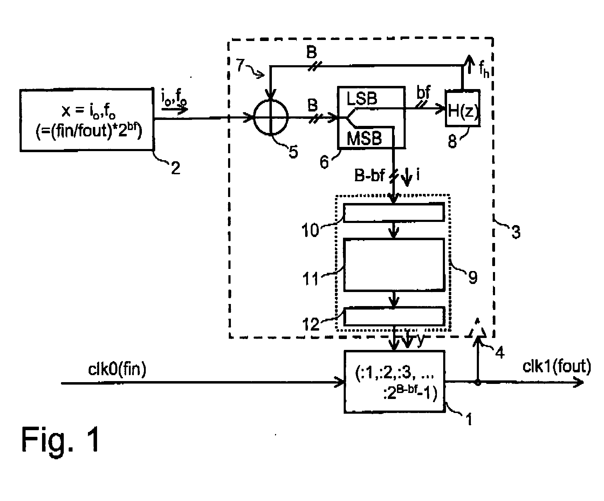

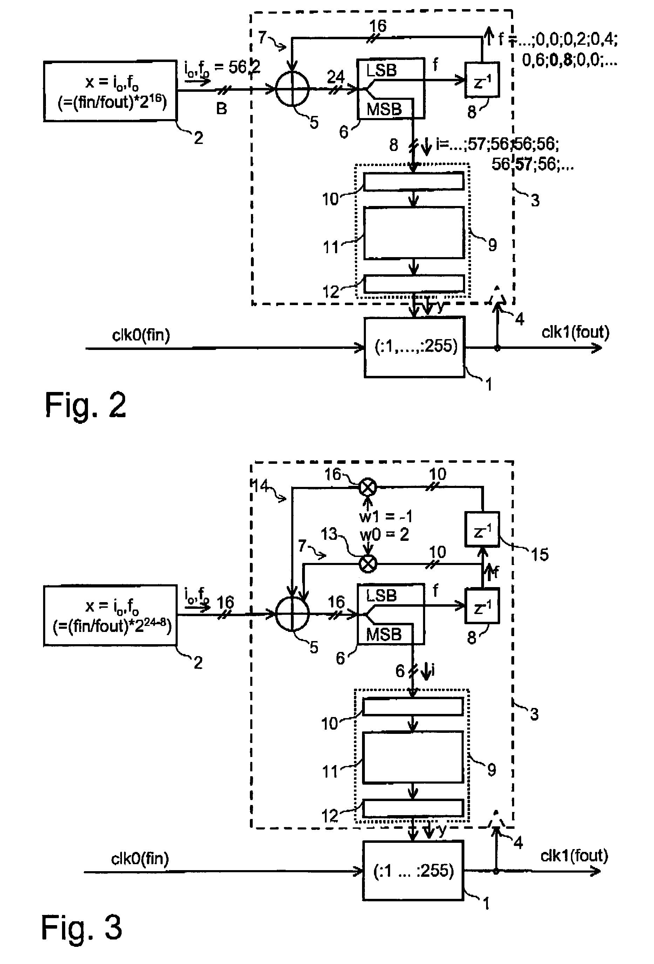

Die grundlegenden Prinzipien werden anhand des einfachen Ausführungsbeispieles in Fig. 2 erläutert, wobei Fig. 1 eine dazu entsprechende Ausführungsform mit beispielhaften Zahlenwerten zeigt.

Fig. 1 und 2 zeigen einen beispielhaften digitalen Taktteiler mit einer Taktteilungseinrichtung 1, an deren Eingang ein erster Takt clk0 mit einer ersten hohen Frequenz fin anliegt. Auf Basis eines an der Taktteilungseinrichtung 1 anliegenden Steuerwerts bzw. Steuersignals als einem Teilerfaktor y und dem ersten Takt clk0 stellt die Taktteilungseinrichtung 1 an ihrem Ausgang einen zweiten Takt clk1 mit einer relativ zur ersten Frequenz fin niedrigeren zweiten Frequenz fout bereit.

Von beispielsweise einer Teilungswert-Speichereinrichtung 2 wird ein Teilungswert x bereitgestellt, welcher das gewünschte Verhältnis der Taktraten bzw. Frequenzraten zwischen der ersten Frequenz fin und der zweiten Frequenz fout angibt. Ein solcher Teilungswert x ist dabei darstellbar durch einen darin enthaltenen ganzzahligen Anteil io und einen darin enthaltenen Fraktionalanteil fo in Form von entsprechenden Ziffern vor bzw. nach dem Dezimalzeichen bzw. Komma.

Ausgegeben wird der Teilungswert x entsprechend über eine parallele Leitungsanordnung, insbesondere einen Bus, wie dies gemäß Fig. 1 mittels eines Bus mit B Leitungen oder gemäß Fig. 2 mit 24 Leitungen dargestellt ist. Beispielhaft sollen dabei die ersten acht Leitungen Bits für den im Teilungswert x enthaltenen ganzzahligen Wert i und die 16 weiteren Leitungen Bits für den im Teilungswert x enthaltenen Fraktionalanteil fo tragen. Alternativ kann beispielsweise auch eine serielle Übertragung vorgenommen werden, wobei beispielsweise eine Bitfolge mit 24 Bit übertragen werden würde, von denen z.B. die 16 niedrig-signifikanten Bits (LSB / Least Significant Bits) zur Repräsentation des im Teilungswert x enthaltenen Fraktionalanteils fo und die acht höchst-signifikanten Bits (MSB / Most Significant Bits) den ganzzahligen Wert repräsentieren.

Der Teilungswert x, beispielsweise in Fig. 2 die Zahl 56,2, wird einer Teilerfaktor-Erzeugungseinrichtung 3 angelegt, welche den Teilerfaktor y bereitstellt. Die Bereitstellung des Teilerfaktors y erfolgt durch die Teilerfaktor-Erzeugungseinrichtung 3 auf Basis des angelegten Teilungswerts x und des außerdem an der Teilerfaktor-Erzeugungseinrichtung 3 an einem Takteingang 4 angelegten zweiten Takts clk1 mit der niedrigeren zweiten Frequenz fout.

In der Teilerfaktor-Erzeugungseinrichtung 3 wird der Teilungswert x einem Addierer 5 angelegt. Ein Additionswert des Addierers 5 wird einer Teilungswert-Teilungseinrichtung 6 angelegt, welche eine Aufsplittung bzw. Teilung in einen abgetrennten Fraktionalanteil f und in einen abgetrennten ganzzahligen Wert i des angelegten Wertes vornimmt. Im Fall eines angelegten Busses mit beispielsweise B (Fig. 1) bzw. 24 (Fig. 2) Leitungen werden die bf (Fig. 1) bzw. 16 (Fig. 2) Leitungen, welche den Nach-Komma-Anteil des angelegten Wertes tragen, von den B - bf (Fig. 1) bzw. 8 (Fig. 2) Leitungen getrennt, welche den ganzzahligen Wert i bzw. Vor-Komma-Anteil des angelegten Wertes tragen. Im Fall eines seriellen angelegten Wertes werden die insbesondere höchst-signifikanten Bit MSB, welche den ganzzahligen Wert i repräsentieren, von den niedrig-signifikanten Bit LSB, welche den Wert des Fraktionalanteils f tragen, getrennt.

Der Fraktionalanteil f bzw. insbesondere vorzugsweise dessen Betragswert wird einer Rückkoppelungsstrecke 7 angelegt, welche eine weitere Verarbeitungseinrichtung 8 als z.B. eine verzögerungseinrichtung aufweist und den jeweils angelegten Fraktionalanteil f um insbesondere einen Takt verzögert zu einem zweiten Eingang des Addierers 5 zurückführt. Der Fraktionalteil ist eine positive Zahl, so dass der Ausgang der Verzögerungseinrichtung einen vorne mit Nullen auf die Addiererwortbreite aufgefüllten fraktionalen Wert fₕ darstellt. Der Addierer 5 addiert somit den jeweils angelegten Teilungswert x und den im vorherigen Takt vom Additionsergebnis abgetrennten Fraktionalanteil f. Die Taktung des Addierers 5, der Teilungswert-Teilungseinrichtung 6 und der Verzögerungseinrichtung erfolgt dabei mittels des am Takteingang 4 angelegten zweiten Takts clk1. Die Verarbeitungseinrichtung 8 kann eine Filterung mit einer Übertragungsfunktion H(z) (Fig. 1) bzw. z⁻¹ (Fig. 2) beinhalten. Für bevorzugte Ausführungen gilt 1 - H(z) = 0 für z = 1, womit der Taktteiler im Mittel die richtige Frequenz generiert.

Bei beispielsweise einem angelegten Teilungswert x gleich 56,2 und einem anfänglichen Fraktionalanteil f gleich Null 0 würde der Addierer 5 als ersten Additionswert den Wert 56,2 an der Teilungswert-Teilungseinrichtung 6 anlegen. Als Fraktionalanteil f würde diese für den nächsten Takt den Wert 0,2 zum Addierer 5 zurückführen, so dass das nächste Additionsergebnis beim zweiten Takt den Additionswert 56,4 ergibt. Für den dritten Takt wird dem Addierer entsprechend ein Fraktionalanteil f mit dem Wert 0,4 angelegt, für den vierten Takt ein Fraktionalanteil f mit dem Wert 0,6, für den fünften Takt ein Fraktionalanteil f mit dem Wert 0,8 und für den sechsten Takt wieder der anfängliche Fraktionalanteil f mit dem Wert 0,0. Dadurch ergibt sich eine vorzugsweise zyklische Abfolge von Werten des Fraktionalanteils f, welche dem Addierer 5 zur Addition auf den Teilungswert x angelegt werden. Der von der Teilungswert-Teilungseinrichtung 6 ausgegebene ganzzahlige Wert i hat bei dem beschriebenen Beispiel einen anfänglichen Wert gleich 56, welcher über eine Folge von vier Takten gehalten wird, bis im fünften Takt durch die Addition der Additionswert 57 erzielt wird. Beim fünften Takt wird entsprechend ein ganzzahliger Wert i mit dem Wert 57 ausgegeben. Im nachfolgenden Takt wird wieder der Wert 56 als ganzzahliger Wert i ausgegeben. Entsprechend weist auch die zeitliche Abfolge der ganzzahligen Werte i eine zyklische Abfolge auf.

Der Teilungswert x kann gemäß einer beispielhaften und als vorteilhaft bestimmten Weise festgelegt werden als Zweierpotenz der Anzahl bf (Fig. 1) bzw. 16 (Fig. 2) der Stellen bzw. Leitungen des abzutrennenden Fraktionalanteils f.Der ganzzahlige Wert i kann direkt als Teilerfaktor y der Taktteilungseinrichtung 1 angelegt werden, wenn sie als normaler Zähler im Binärsystem ausgeführt ist. Vorzugsweise wird der ganzzahlige Wert i jedoch zwischengespeichert und/oder zwischenverarbeitet. Dazu kann der ganzzahlige Wert i einer Zwischenspeichereinrichtung 9 angelegt werden, welche beispielsweise als ein einfaches Register oder Latch ausgebildet ist.

Bei der beispielhaft dargestellten und besonders bevorzugten Anordnung ist diese Zwischenspeichereinrichtung 9 jedoch komplexer ausgebildet und weist in Folge ein optionales erstes Register 10, einen Chain-Counter-Recoder-Block 11 und ein optionales zweites Register 12 auf, welchem in dieser Folge der ganzzahlige Wert i angelegt wird. Dieser Block setzt die im binären Zahlensystem codierte Steuerinformation für die in einem Chain-Counter benötigte binäre Restklassen-Polynomdarstellung um. Dieses ist für den Fall notwendig, wenn die Teilungseinrichtung 1 als Chain-Counter ausgeführt ist und die notwendige Recodierung vom binären System auf das Polynomrestklassensystem nicht in ihr selbst ausgeführt wird. Das zweite Register 12 stellt dann den Teilerfaktor y für die Taktteilungseinrichtung 1 bereit. Die Taktung des ersten Registers, des Chain-Counter-Recoder-Blocks 11 und des zweiten Registers 12 erfolgt vorzugsweise ebenfalls mit dem zweiten Takt clk1 mit der niedrigeren zweiten Frequenz fout.

Fig. 3 zeigt eine besonders bevorzugte zweite Ausführungsform eines digitalen Taktteilers. Beschrieben werden nachfolgend lediglich Komponenten und Aspekte, welche einen konstruktiven und/oder funktionellen Unterschied zu entsprechenden Komponenten oder Verfahrensschritten gemäß der vorstehenden Ausführungsform aufweisen.

Beispielsweise weist der Teilungswert x gemäß der zweiten Ausführungsform eine Wertlänge und/oder -breite von 16 Bit auf, von denen wieder beispielsweise die 6 höchst-signifikanten Bits MSB als ganzzahliger Wert i in der Teilungswert-Teilungseinrichtung 6 abgezweigt werden. Die übrigen 10 Bits bilden als niedriger-signifikante Bits LSB den Fraktionalanteil f, welcher der Rückkoppelungsstrecke 7 zugeführt wird. Prinzipiell sind jedoch auch beliebige andere Anzahlen von Bits zur Darstellung des Teilungswertes x und/oder zur Aufsplittung in Anteile für den Fraktionalanteil f und den ganzzahligen Wert i wählbar.

Als Besonderheit ist in der Rückkoppelungsstrecke 7 als zusätzliche Komponente ein Multiplizierer 13 eingesetzt, welcher zur Wichtung des momentan von der Verarbeitungseinrichtung 8 angelegten Fraktionalanteils f mit einem Wichtungsfaktor w0 dient. Beispielsweise ist als Wichtungsfaktor w0 der Wert 2 vorgegeben, wodurch der Multiplizierer als einfacher Verschiebeeinrichtung (engl. Shifter) mit fester Verschiebung ausgeführt werden kann.

Als weiteren Unterschied gegenüber der Ausführungsform gemäß Fig. 1 oder 2 weist die anhand Fig. 3 dargestellte Ausführungsform zusätzlich zu dem Multiplizierer 13 oder alternativ zu diesem eine zweite Rückkoppelungsstrecke 14 auf. Die zweite Rückkoppelungsstrecke 14 umfasst eine zweite Verarbeitungseinrichtung 15 in Form z,B, einer Verzögerungseinrichtung, um einen von der ersten Verarbeitungseinrichtung in Form z.B. wieder einer Verzögerungseinrichtung ausgegebenen und um einen Takt verzögerten Fraktionalanteil f um einen weiteren Takt zu verzögern, bevor dieser somit um zwei Takte verzögerte Fraktionalanteil als weiterer zu addierender Wert am Addierer 5 angelegt wird. Vorzugsweise weist auch die zweite Rückkoppelungsstrecke 14 einen Multiplizierer 16 auf, welcher den zweifach verzögerten Fraktionalanteil mit einem weiteren, zweiten Wichtungsfaktor w1 multipliziert, Beispielhaft ist als zweiter Wichtungsfaktor w1 der negative Wert -1 dargestellt, so dass der zweifach verzögerte Wert durch den Addierer 5 nicht addiert sondern subtrahiert wird.

Wie insbesondere dieser Ausführungsform entnehmbar ist, kann der Addierer 5 durch Anlegen eines negativen Wertes entsprechend auch als Subtraktionsglied eingesetzt werden. Prinzipiell ist anstelle einer kontinuierlichen Addition auch eine kontinuierliche Subtraktion der Fraktionalanteile f von dem Teilungswert x als weitere alternative Ausführungsform möglich. Ebenso wird in dieser Ausführungsform deutlich, dass der Addierer 5 in die Implementation der Übertragungsfunktion H(z) einbezogen werden kann.

## Patentansprüche

1. Digitaler Taktteiler mit
- einem Addierer (5) und
- einer Taktteilungseinrichtung (1), an der ein erster Takt (c1k0) mit einer ersten hohen Frequenz (fin) anliegt und die einen zweiten Takt (c1k1) mit einer relativ zur ersten Frequenz (fin) niedrigeren zweiten Frequenz (fout) ausgibt,
**dadurch gekennzeichnet, dass**
- eine Teilungswert-Teilungseinrichtung (6) ausgebildet ist, einen vom Addierer (5) ausgegebenen Additionswert (i, f) in einen ganzzahligen Wert (i) und einen Fraktionalanteil (f) aufzuteilen,
- eine Rückkoppelungsstrecke (7; 7, 14) den Fraktionalanteil (f) oder einen von einer Verarbeitungseinrichtung (8) modifizierten Fraktionalanteil (fₕ) für eine Addition zum Addierer (5) zurückführt,
- der Addierer (5) den zurückgeführten Fraktionalanteil (f) auf einen anliegenden Teilungswert (x) aufaddiert und
- die Taktteilungseinrichtung (1) auf Basis des ganzzahligen Werts (i) gesteuert wird.

2. Taktteiler nach Anspruch 1, bei dem zumindest der Addierer (5) und die Teilungswert-Teilungseinrichtung (6) mittels des zweiten Takts (clk1) getaktet betrieben werden.

3. Taktteiler nach Anspruch 1 oder 2, bei dem in die Rückkoppelungsstrecke (7) eine Verarbeitungseinrichtung (8) geschaltet ist zum verzögerten oder verarbeiteten Rückführen des Fraktionalanteils (f).

4. Taktteiler nach einem vorstehenden Anspruch, bei dem mehrere Rückkoppelungsstrecken (7, 14) verschieden stark verzögerte Fraktionalanteile (f) zum Addierer (5) rückführen.

5. Taktteiler nach einem vorstehenden Anspruch, bei dem in die eine Rückkoppelungsstrecke (7) oder mehrere Rückkoppelungsstrecken (7, 14) Multiplizierer, Dividierer, Inverter oder Shifter zum Wichten der rückgeführten Fraktionalanteile (f) geschaltet sind.

6. Taktteiler nach einem vorstehenden Anspruch, bei dem eine Teilungswert-Speichereinrichtung (2) angeordnet ist, den an dem Addierer (5) anliegenden Teilungswert (x) bereitzustellen.

7. Taktteiler nach einem vorstehenden Anspruch, bei welchem der ganzzahlige Wert (i) innerhalb einer Zyklusposition eines Taktzyklus einen um einen festen Betrag erniedrigten oder erhöhten Wert (57) gegenüber einem Wert (56) sonstiger Zykluspositionen des Zyklus aufweist.

8. Taktteiler nach einem vorstehenden Anspruch, bei dem eine zwischen die Teilungswert-Teilungseinrichtung (6) und die Taktteilungseinrichtung (1) geschaltete Zwischenspeichereinrichtung (9) den ganzzahligen Wert (i) zwischenspeichert.

9. Taktteiler nach einem vorstehenden Anspruch, bei dem die Taktteilungseinrichtung (1) den ganzzahligen Wert (i) im nicht-binären Zahlensystem abzählt.

10. Taktteiler nach einem vorstehenden Anspruch, bei dem die Taktteilungseinrichtung (1) den ganzzahligen Wert (i) mit einem Chain-Counter abzählt.

11. Taktteiler nach einem vorstehenden Anspruch, bei dem zwischen die Teilungswert-Teilungseinrichtung (6) und die Taktteilungseinrichtung (1) ein Recoder-Block geschaltet ist, der den ganzzahligen Wert (i) in eine Repräsentation überführt, die von der Taktteilungseinrichtung (1), die im nicht-binären Zahlensystem zählt, verarbeitet wird.

12. Taktteiler nach einem vorstehenden Anspruch, bei dem zwischen die Teilungswert-Teilungseinrichtung (6) und die Taktteilungseinrichtung (1) ein Recoder-Block (11) geschaltet ist, der den ganzzahligen Wert (i) in eine Repräsentation überführt, welche die als ein Chain-Counter implementierte Taktteilungseinrichtung (1) steuert.

13. Verfahren zum Betreiben eines digitalen Taktteilers, insbesondere zum Betreiben eines digitalen Taktteilers nach einem vorstehenden Anspruch, bei dem auf einen Teilungswert (x) ein Fraktionalanteil (f) aufaddiert wird, wobei der Fraktionalanteil in zyklischer Abfolge vom Additionswert der Addition getrennt und für eine nachfolgende Addition rückgeführt wird und wobei ein ganzzahliger Wert (i) der Addition als Teilerfaktor (y) oder Basis für einen Teilerfaktor (y) einer Taktteilungseinrichtung (1) zum Bereitstellen eines zweiten Takts (clk1) mit niedrigerer Frequenz (fout) aus einem ersten Takt (clk0) mit höherer Frequenz (fin) angelegt wird.

14. Verfahren nach Anspruch 13, bei dem der Teilerfaktor (y) auf Basis des zweiten Takts (clk1) erzeugt und bereitgestellt wird.

15. Verfahren nach Anspruch 13 oder 14, bei dem der Fraktionalanteil (f) des Additionswertes über verschiedene Rückkoppelungsstrecken (7, 14) verschieden stark verzögert rückgeführt wird.

16. Verfahren nach einem der Ansprüche 13 bis 15, bei dem der oder die rückgeführten Fraktionalanteile (f) gewichtet werden.
